# EUROPEAN PATENT SPECIFICATION

(11) **EP 1 894 982 B1**
(45) Date of publication and mention of the grant of the patent: **09.04.2014**
(21) Application number: 07017036.0
(22) Date of filing: 30.08.2007
(51) Int. Cl.: C09J 11/08

(54) **Pressure-sensitive adhesive tape or sheet for application to active surface in dicing and method of picking up cut pieces of work**
Druckempfindliches Klebeband oder -blatt zum Anbringen auf einer aktiven Oberfläche beim Zerschneiden und Verfahren zum Aufnehmen der anfallenden Werkstücke
Bande ou feuille adhésive sensible à la pression pour une application sur une surface active pour une fragmentation et procédé pour ramasser des morceaux découpés

(30) Priority: 01.09.2006 JP 2006237149
(43) Date of publication of application: 05.03.2008
(73) Proprietor: NITTO DENKO CORPORATION, Osaka (JP)
(72) Inventor: Okawa, Yuji, Ibaraki-shi Osaka (JP); Takahashi, Tomokazu, Ibaraki-shi Osaka (JP); Asai, Fumiteru, Ibaraki-shi Osaka (JP); Shintani, Toshio, Ibaraki-shi Osaka (JP)
(74) Representative: Grünecker, Kinkeldey, Stockmair & Schwanhäusser

(56) References cited:
- EP-A- 1 108 770
- EP-A- 1 724 106

## Description

### FIELD OF THE INVENTION

The present invention relates to a pressure-sensitive adhesive tape or sheet for application to an active surface in dicing and a method of picking up cut pieces of a work with the use of the pressure-sensitive adhesive tape or sheet. More particularly, the invention relates to a pressure-sensitive adhesive tape or sheet for application to an active surface in dicing, which is used in such a manner that, when a work made of a material comprising a compound such as a silicon compound, germanium compound, or gallium-arsenic compound (e.g., a semiconductor wafer, semiconductor package, glass, or ceramic) is to be diced and the resultant cut pieces are to be picked up, the tape or sheet is applied to the active surface of the work which is in the state of being not wholly covered with a native oxide film. The invention further relates to a method of picking up cut pieces of a work using the pressure-sensitive adhesive tape or sheet.

### BACKGROUND OF THE INVENTION

In a general process heretofore in use, a semiconductor wafer made of a material comprising a compound such as a silicon compound, germanium compound, or gallium-arsenic compound is produced in a large-diameter form, thereafter subjected to back grinding so as to result in a given thickness, and then subjected to back processing (e.g., etching or polishing) according to the necessity. Subsequently, a pressure-sensitive adhesive tape or sheet for dicing is applied to the back side of the semiconductor wafer. Thereafter, this wafer is cut (diced) into device chips and then subjected to various steps such as a cleaning step, expanding step, pickup step, and mounting step.

The pressure-sensitive adhesive tape or sheet for dicing generally has a constitution containing a substrate constituted of a plastic film or the like and a pressure-sensitive adhesive layer (having a thickness about 1-50 µm) formed on the substrate by applying a pressure-sensitive adhesive composition such as an acrylic pressure-sensitive adhesive, followed by drying it. The pressure-sensitive adhesive tape or sheet for dicing is required to have adhesive strength sufficient to prevent the semiconductor wafer from separating from the tape or sheet during dicing. From this standpoint, the pressure-sensitive adhesive tapes or sheets which have generally been used hitherto for dicing have a peel adhesive strength in the pickup of, e.g., a silicon mirror wafer (peel angle, 15°; pulling rate, 150 mm/min; temperature in application, 23°C; temperature in peeling, 23°C) of 2.5 (N/25-mm width) or higher. On the other hand, the adhesive strength is required to be low in such a degree that in pickup after dicing, the semiconductor wafer can be easily separated from the tape or sheet without breaking. Furthermore, one of the important properties required for pressure-sensitive adhesive tapes or sheets for dicing is the property of less apt to cause contamination, e.g., not to leave an adhesive residue on the semiconductor chips (the phenomenon in which an ingredient in the pressure-sensitive adhesive layer remains on the adherend surface). Disclosed as a pressure-sensitive adhesive tape or sheet for dicing which has such properties is, for example, a removable pressure-sensitive adhesive sheet having a pressure-sensitive adhesive layer constituted of a polymer in which the content of low-molecular components having a molecular weight of 10⁵ or lower is 10% by weight or lower (see, JP-A-2001-234136).

Incidentally, the pickup step is usually conducted after the expanding step, in which the space between semiconductor chips is enlarged. The expanding step is a step in which the semiconductor chips are made easily separable from the pressure-sensitive adhesive tape or sheet for dicing. This expanding step is accomplished, for example, by keeping the pressure-sensitive adhesive tape or sheet for dicing in the state of being stretched in some degree and lifting up that point area or linear area of the pressure-sensitive adhesive tape or sheet for dicing which underlies the semiconductor chip to be picked up. In the method which is being mainly employed currently, semiconductor chips are brought into such an easily separable state and then held from the upper side with suction (vacuum holding) and picked up.

In recent years, however, the case where a semiconductor wafer is bonded to a pressure-sensitive adhesive tape or sheet for dicing within several hours after completion of a wafer back grinding step or after completion of a wafer back grinding step and a subsequent grinding dust layer removal step (step of mechanical grinding dust layer removal, chemical grinding dust layer removal, or grinding dust layer removal by both) has become frequent for the purposes of improving tact time, preventing semiconductor wafers having a reduced thickness from breaking, etc. Examples of the grinding dust layer removal step include various treatments such as a dry polishing treatment, so-called "CMP" treatment, wet etching treatment, and dry etching treatment.

When a pressure-sensitive adhesive tape or sheet for dicing is thus applied to the ground surface (processed surface) of a semiconductor wafer within several hours after completion of a wafer back grinding step or after completion of a grinding dust layer removal step after grinding, there is a problem that the adhesive strength increases as time passes after the application (with the lapse of time), resulting in a decrease in suitability for pickup. The reasons for this are presumed to be as follows. The ground surface of the semiconductor wafer has not been wholly covered with a native oxide film and is an active surface in which active atoms in an unoxidized state are present. Since the pressure-sensitive adhesive tape or sheet for dicing has been applied to such active surface not wholly covered with a native oxide film, the active atoms in an unoxidized state (e.g., silicon atoms) react with a component of the pressure-sensitive adhesive layer to form chemical bonds between the unoxidized active atoms and the component of the pressure-sensitive adhesive layer and thereby pose that problem.

### SUMMARY OF THE INVENTION

Accordingly, an object of the invention is to provide a pressure-sensitive adhesive tape or sheet for application to an active surface in dicing which, when used in dicing, enables conducting the dicing satisfactorily, and even when kept adherent to an active surface for a prolonged period of time, enables the cut pieces to be easily picked up. Another object of the invention is to provide a method of picking up cut pieces of a work, which includes using the pressure-sensitive adhesive tape or sheet for application to an active surface in dicing.

The present inventors have made intensive investigations in order to accomplish those objects. As a result, they found that use of a pressure-sensitive adhesive tape or sheet for dicing which has a pressure-sensitive adhesive layer containing a given amount of a compound having a hydroxy group or a derivative thereof enables the dicing of a semiconductor wafer to be satisfactorily conducted, and that when this pressure-sensitive adhesive tape or sheet for dicing is applied to the ground surface, which is an active surface, of a semiconductor wafer immediately after back grinding (back processing) of the wafer, then this pressure-sensitive adhesive tape or sheet can be easily stripped off even after the passage of a prolonged time period. The invention has been completed based on these findings.

### BRIEF DESCRIPTION OF THE DRAWINGS

Fig. 1 is a diagrammatic sectional view illustrating one embodiment of the pressure-sensitive adhesive tape or sheet for application to an active surface in dicing of the invention.
Fig. 2 is a diagrammatic sectional view illustrating a method of measuring the adhesive strength of a pressure-sensitive adhesive tape or sheet for application to an active surface in dicing.

### Description of the Reference Numerals

1 : pressure-sensitive adhesive tape or sheet for application to active surface in dicing
2 : substrate
3 : hydroxy-compound-containing pressure-sensitive adhesive layer
4 : separator
5 : silicon mirror wafer
θ : angle between the surface of hydroxy-compound-containing pressure-sensitive adhesive layer 3 and the surface of silicon mirror wafer 5 (peel angle)
a : direction in which pressure-sensitive adhesive tape or sheet 1 for application to active surface in dicing is stripped off (pulling direction)

### DETAILED DESCRIPTION OF THE INVENTION

Namely, the present invention relates to the followings.
(1) A pressure-sensitive adhesive tape or sheet for dicing, which comprises a substrate and a pressure-sensitive adhesive layer disposed on at least one side of the substrate,
   wherein said pressure-sensitive adhesive layer disposed on at least one side of the substrate contains a compound having a hydroxy group or a derivative thereof in an amount of 2 to 12% by weight based on all ingredients, and
   wherein the pressure-sensitive adhesive tape or sheet is to be applied to an active surface in the state of being not wholly covered with a native oxide film.
(2) The pressure-sensitive adhesive tape or sheet according to (1), wherein the compound having a hydroxy group or the derivative thereof is a polyalkylene glycol or a derivative thereof.
(3) The pressure-sensitive adhesive tape or sheet according to (2), wherein the polyalkylene glycol is polyethylene glycol or polypropylene glycol.
(4) The pressure-sensitive adhesive tape or sheet according to (2), wherein the polyalkylene glycol is polypropylene glycol.
(5) The pressure-sensitive adhesive tape or sheet according to (1), wherein the pressure-sensitive adhesive layer is a radiation-curable pressure-sensitive adhesive layer.
   The compound having a hydroxy group or the derivative thereof preferably is a polyalkylene glycol or a derivative thereof The polyalkylene glycol preferably is polyethylene glycol or polypropylene glycol. The pressure-sensitive adhesive layer preferably is a radiation-curable pressure-sensitive adhesive layer.
   The present invention further relates to the followings.
(6) A method of picking up a cut piece of a work, comprising:
   applying the pressure-sensitive adhesive tape or sheet according to (1) to an active surface of a work, followed by dicing the work; and then
   picking up a resultant cut piece of the work.
(7) The method according to (6), wherein the work is a semiconductor wafer having a thickness of smaller than 100 µm.
   In this method, the work preferably is a semiconductor wafer having a thickness of smaller than 100 µm.
   The present invention still further relates to the following.
(8) A semiconductor device produced by dicing a semiconductor wafer and picking up a resultant cut piece, the semiconductor device being obtainable by the method according to (6).

In this specification, the term "(meth)acrylic ester" means an acrylic ester and/or a methacrylic ester. The term "(meth)" herein has the same meaning in every case.

Since the pressure-sensitive adhesive tape or sheet for application to an active surface in dicing of the invention has the constitution described above, dicing with this pressure-sensitive adhesive tape or sheet can be satisfactorily conducted and the pressure-sensitive adhesive tape or sheet enables the cut pieces to be easily picked up even after having been kept adherent to an active surface over a prolonged time period.

The pressure-sensitive adhesive tape or sheet for application to an active surface in dicing of the invention includes a substrate and a pressure-sensitive adhesive layer disposed on at least one side of the substrate, in which the pressure-sensitive adhesive layer disposed on at least one side of the substrate contains a compound having a hydroxy group or a derivative thereof (often referred to as "hydroxy compound") in an amount of 2 to 12% by weight based on all ingredients. Since the pressure-sensitive adhesive layer disposed on at least one side of the substrate in the pressure-sensitive adhesive tape or sheet of the invention contains a hydroxy compound in an amount of 2 to 12% by weight based on all ingredients, it produces the following effects. When this pressure-sensitive adhesive tape or sheet is applied to a surface (active surface) which is in the state of being not wholly covered with a native oxide film and having active atoms in an unoxidized state (often referred to as "active atoms"), then the base polymer of the pressure-sensitive adhesive constituting the pressure-sensitive adhesive layer can be inhibited or prevented from forming chemical bonds with such active atoms due to the presence of a given amount of the hydroxy compound on the surface of the pressure-sensitive adhesive layer. Furthermore, for example, in the case where the pressure-sensitive adhesive layer is one constituted of a radiation-curable pressure-sensitive adhesive (radiation-curable pressure-sensitive adhesive layer), a radiation-curable ingredient (e.g., a radiation-curable oligomer) in this radiation-curable pressure-sensitive adhesive layer can be inhibited or prevented from forming chemical bonds with active atoms when it undergoes a curing reaction upon irradiation with a radiation, due to the presence of the hydroxy compound on the surface of the pressure-sensitive adhesive layer. It is also thought that in some cases, the presence of the hydroxy compound on the surface of the pressure-sensitive adhesive layer results in the formation of chemical bonds between the hydroxy compound and active atoms, whereby the activity of the active atoms present on the active surface may be reduced. Consequently, even when the pressure-sensitive adhesive tape or sheet of the invention is kept adherent to an active surface over a prolonged time period, the adhesion strength between the active surface and the surface of the pressure-sensitive adhesive layer can be inhibited or prevented from becoming too high and the cut pieces can be easily picked up.

Since the pressure-sensitive adhesive tape or sheet of the invention has the constitution in which the pressure-sensitive adhesive layer contains a hydroxy compound in a proper proportion, it can exhibit moderate adhesive strength. Therefore, when the pressure-sensitive adhesive tape or sheet of the invention is used in dicing a semiconductor wafer, the cut pieces can be inhibited or prevented from scattering (or shedding) and the wafer can be satisfactorily diced.

Herein, the term "active surface" means a surface which is in the state of being not wholly covered with a native oxide film. Specifically, it means a surface which is not wholly covered with a native oxide film and in which active atoms in an unoxidized state (e.g., atoms reactive with a component of the pressure-sensitive adhesive layer) are present.

### Hydroxy Compound

The hydroxy compound (compound having a hydroxy group or a derivative thereof) is not particularly limited so long as it is either a compound having at least one hydroxyl group in the molecule thereof or a derivative of the compound. It can be suitably selected from conventional compounds having a hydroxy group or derivatives thereof. Specific examples of the hydroxy compound include polyalkylene glycols or derivatives thereof (e.g., ether glycols and ester glycols), polyhydric alcohols or derivatives thereof (e.g., ethers of polyhydric alcohols and esters of polyhydric alcohols), saccharides or derivatives thereof, monohydric alcohols or derivatives thereof, thickening polysaccharides or derivatives thereof, and hydroxy carboxylic acids or derivatives thereof (e.g., alkali metal salts and esters). Such hydroxy compounds may be used alone or in combination of two or more thereof.

In the invention, it is preferred to use a polyol compound having two or more hydroxyl groups in the molecule thereof or a derivative thereof (in particular, a polyether polyol compound or derivative thereof) as the hydroxy compound. For example, the hydroxy compound preferably is a polyol compound or derivative thereof, such as a polyalkylene glycol or derivative thereof, a polyhydric alcohol or derivative thereof, or a saccharide or derivative thereof. In particular, a polyether polyol compound or derivative thereof, such as a polyalkylene glycol or derivative thereof, is preferred.

More specifically, examples of the polyalkylene glycol include polyethylene glycol, polypropylene glycol, polytetramethylene glycol, and ethylene glycol/propylene glycol copolymers. Examples of the polyalkylene glycol derivative include polyoxyalkylene alkyl ethers such as polyoxyethylene alkyl ethers (e.g., polyoxyethylene lauryl ether) and polyoxypropylene alkyl ethers (e.g., polyoxypropylene lauryl ether); polyoxyalkylene aryl ethers such as polyoxyethylene aryl ethers (e.g., polyoxyethylene phenyl ether) and polyoxypropylene aryl ethers (e.g., polyoxypropylene phenyl ether); and polyoxyalkylene fatty acid esters such as polyoxyethylene fatty acid esters and polyoxypropylene fatty acid esters.

Preferred of such polyalkylene glycols and derivatives thereof are the polyalkylene glycols. Preferred of the polyalkylene glycols are polyethylene glycol and polypropylene glycol. Polypropylene glycol is especially preferred.

In such polyalkylene glycols and derivatives thereof, the number-average molecular weight of each polyalkylene glycol can be suitably determined according to affinity for the base polymer of the pressure-sensitive adhesive, etc. However, the number-average molecular weight thereof is preferably 3,000 or lower, more preferably 2,000 or lower (especially 1,000 or lower). The lower limit of the number-average molecular weight of the polyalkylene glycol is not particularly limited and may be suitably determined according to the kind thereof. For example, the polyalkylene glycol may have such a molecular weight that the number of the alkylene glycol units as repeating units is 4. Consequently, when the polyalkylene glycol is polypropylene glycol, the number-average molecular weight of the polypropylene glycol may be, for example, 300 or higher, preferably 400 or higher (more preferably 500 or higher).

Examples of the polyhydric alcohol include glycerol, polyglycerol (e.g., diglycerol or polyglycerol made up of three or more glycerol molecules), ethylene glycol, diethylene glycol, triethylene glycol, propylene glycol, dipropylene glycol, tripropylene glycol, 1,3-propanediol, 1,3-butanediol, 1,4-butanediol, 1,5-pentanediol, neopentyl glycol, 1,6-hexanediol, pentaerythritol, trimethylolethane, and trimethylolpropane. Examples of the polyhydric-alcohol derivative include glycol ethers such as ethylene glycol monoethyl ether, ethylene glycol monobutyl ether, diethylene glycol monoethyl ether, diethylene glycol monobutyl ether, propylene glycol monoethyl ether, and propylene glycol monobutyl ether; glycol ether acetates such as ethylene glycol monoethyl ether acetate and propylene glycol monoethyl ether acetate; glycol esters such as ethylene glycol fatty acid esters and propylene glycol fatty acid esters; and glycerol compound fatty acid esters such as glycerol fatty acid esters and polyglycerol fatty acid esters.

Examples of the saccharide or derivative thereof include monosaccharides such as erythrose, threose, ribose, arabinose, xylose, lyxose, allose, altrose, glucose, mannose, gulose, idose, galactose, talose, erythrulose, ribulose, xylulose, psicose, fructose, sorbose, and tagatose and derivatives thereof (e.g., deoxysugars, amino sugars, branched sugars, acids, and lactones). Examples thereof further include polysaccharides [e.g., disaccharides such as isomaltose, gentiobiose, sucrose, cellobiose, sophorose, trehalose, isotrehalose, palatinose, maltose, melibiose, and lactose; trisaccharides such as maltotriose and isomaltotriose; and tetrasaccharides such as maltotetraose], cyclodextrins, oligosaccharides, and sugar alcohols (e.g., erythritol, threitol, ribitol, arabitol, xylitol, allitol, altritol, glucitol, mannitol, iditol, galactitol, sorbitol, isomaltitol, maltitol, lactitol, maltotriitol, and isomaltotriitol).

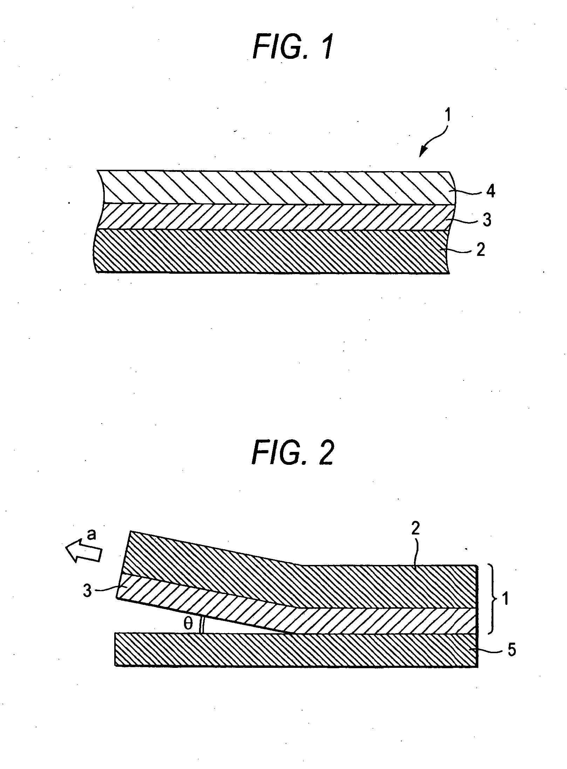

As shown in Fig. 1, the pressure-sensitive adhesive tape or sheet of the invention includes a substrate and a pressure-sensitive adhesive layer disposed on at least one side of the substrate, the pressure-sensitive adhesive layer containing a hydroxy compound in an amount of 2 to 12% by weight based on all ingredients (this pressure-sensitive adhesive layer is often referred to as "hydroxy-compound-containing pressure-sensitive adhesive layer"). Fig. 1 is a diagrammatic sectional view illustrating one embodiment of the pressure-sensitive adhesive tape or sheet of the invention. In Fig. 1, numeral 1 denotes the pressure-sensitive adhesive tape or sheet for application to an active surface in dicing, numeral 2 denotes a substrate, numeral 3 denotes a hydroxy-compound-containing pressure-sensitive adhesive layer, and numeral 4 denotes a separator. The hydroxy-compound-containing pressure-sensitive adhesive layer 3 is a pressure-sensitive adhesive layer which contains a hydroxy compound in an amount of 2 to 12% by weight based on all ingredients. The pressure-sensitive adhesive tape or sheet 1 shown in Fig. 1 has a constitution in which a hydroxy-compound-containing pressure-sensitive adhesive layer 3 and a separator 4 are superposed in this order on one side of a substrate 2 (i.e., a constitution in which a hydroxy-compound-containing pressure-sensitive adhesive layer 3 is formed on one side of a substrate 2 and this hydroxy-compound-containing pressure-sensitive adhesive layer 3 is protected with a separator 4).

Although the pressure-sensitive adhesive tape or sheet shown in Fig. 1 has a hydroxy-compound-containing pressure-sensitive adhesive layer on one side of the substrate, the pressure-sensitive adhesive tape or sheet of the invention should not be construed as being limited to this embodiment. For example, it may have a constitution in which hydroxy-compound-containing pressure-sensitive adhesive layers are formed on both sides of the substrate.

### Substrate

The substrate in the pressure-sensitive adhesive tape or sheet for application to an active surface in dicing serves as a strength base. The substrate may be any of a substrate made of a plastic, substrate made of a metal, substrate made of fibers, substrate made of paper, and the like. However, it is preferred to use a substrate made of a plastic. Examples of the substrate made of a plastic include films or sheets made of plastics. Examples of the materials constituting the plastic films or sheets include polyolefin resins (e.g., low-density polyethylene, linear polyethylene, medium-density polyethylene, high-density polyethylene, ultralow-density polyethylene, propylene random copolymers, propylene block copolymers, propylene homopolymers, polybutene, and polymethylpentene), ethylene/vinyl acetate copolymers, ionomer resins, ethylene/(meth)acrylic acid copolymers, ethylene/(meth)acrylic ester copolymers (e.g., random copolymers and alternating copolymers), ethylene/butene copolymers, ethylene/hexene copolymers, polyurethanes, polyester resins (e.g., poly(ethylene terephthalate), poly(ethylene naphthalate), poly(butylene terephthalate), and poly(butylene naphthalate)), polyimides, polyamides, polyetherketones, polyethers, polyethersulfones, polystyrene resins (e.g., polystyrene), poly(vinyl chloride), poly(vinylidene chloride), poly(vinyl alcohol), poly(vinyl acetate), vinyl chloride/vinyl acetate copolymers, polycarbonates, fluororesins, silicone resins, cellulosic resins, and materials obtained by crosslinking these resins. These constituent materials may be used alone or in combination of two or more thereof The constituent material of the plastic film or sheet may optionally have functional groups incorporated therein, or may be one onto which a functional monomer or modifying monomer has been grafted.

The surface of the plastic substrate may have undergone a conventional or common surface treatment (e.g., a chemical or physical treatment such as corona discharge treatment, chromic acid treatment, ozone exposure treatment, flame exposure treatment, high-voltage electric-shock exposure treatment, or ionizing radiation treatment, coating with an undercoat, priming, matting, or crosslinking) so as to have the enhanced property of adhering to or holding the adjacent layer(s) (e.g., a hydroxy-compound-containing pressure-sensitive adhesive layer). The plastic substrate may have a vapor-deposited layer of a conductive substance such as a metal, alloy, or oxide thereof so as to have antistatic properties. The thickness of the vapor-deposited layer of such a conductive substance is generally about 30 to 500 A.

When the hydroxy-compound-containing pressure-sensitive adhesive layer formed on at least one side of the substrate is a radiation-curable pressure-sensitive adhesive layer which cures upon irradiation with a radiation, then the substrate preferably is one which at least partly transmits a radiation (e.g., X-rays, ultraviolet, or electron beams) so that the radiation-curable pressure-sensitive adhesive layer can be cured upon irradiation with a radiation even from the substrate side.

The substrate may have a single-layer constitution or a multilayer constitution. The substrate may contain conventional additives or ingredients such as a filler, flame retardant, age resistor, antistatic agent, softener, ultraviolet absorber, antiaging agent, plasticizer, and surfactant according to the necessity.

Methods for forming the substrate are not particularly limited, and one suitably selected from conventional or common formation methods can be employed. Examples of methods for forming a plastic substrate include film formation by calendering, film formation by casting, inflation extrusion, and T-die extrusion. In the case of a plastic substrate having a constitution made up of many superposed layers, it can be formed by a laminating technique such as coextrusion or dry laminating. The plastic substrate may be in an unstretched state or may have undergone a stretching treatment and be in a uniaxially or biaxially stretched state.

The thickness of the substrate is not particularly limited and may be suitably determined. However, it is, for example, 10 to 300 µm, preferably 30 to 200 µm.

### Hydroxy-Compound-Containing Pressure-Sensitive Adhesive Layer

In the pressure-sensitive adhesive tape or sheet for application to an active surface in dicing of the invention, it is important that the hydroxy-compound-containing pressure-sensitive adhesive layer on at least one side of the substrate should be one constituted of a pressure-sensitive adhesive composition containing a hydroxy compound in an amount of 2 to 12% by weight based on all ingredients. The thickness of this hydroxy-compound-containing pressure-sensitive adhesive layer is not particularly limited. However, it is preferably 1 to 50 µm. There are cases where a work which has been bonded to the pressure-sensitive adhesive tape or sheet vibrates during dicing. In this case, when the amplitude of vibration is large, the cut pieces (chips) of the work may chip. However, by regulating the thickness of the hydroxy-compound-containing pressure-sensitive adhesive layer to 50 µm or smaller, the amplitude of the vibration occurring in work dicing can be inhibited from becoming too large. As a result, the diminution of the phenomenon in which chips suffer chipping (diminution of the so-called "chipping") can be effectively attained. Furthermore, by regulating the thickness of the hydroxy-compound-containing pressure-sensitive adhesive layer to 1 µm or larger, a work which has been bonded to the hydroxy-compound-containing pressure-sensitive adhesive layer can be held without fail so as to prevent the work from readily separating from the adhesive layer during dicing. The thickness of the hydroxy-compound-containing pressure-sensitive adhesive layer is especially preferably 3 to 20 µm. By thus regulating the thickness of the hydroxy-compound-containing pressure-sensitive adhesive layer to 3 to 20 µm, a further diminution in chipping during dicing can be attained and the work can be fixed with higher certainty during dicing. As a result, the occurrence of dicing failures can be effectively inhibited or prevented.

The hydroxy-compound-containing pressure-sensitive adhesive layer to be used in the invention preferably is one which can be regulated so as to have a peel adhesive strength (peel angle, 15°; pulling rate, 150 mm/sec; temperature 23±3°C) in application to a silicon mirror wafer of 2.3 (N/25-mm width) or lower. When the hydroxy-compound-containing pressure-sensitive adhesive layer is one whose adhesive strength (in application to silicon mirror wafer; peel angle, 15°; pulling rate, 150 mm/sec; 23±3°C) can be regulated to 2.3 (N/25-mm width) or lower, this pressure-sensitive adhesive tape or sheet has satisfactory suitability for pickup and is effective in reducing adhesive transfer (remaining of an ingredient of the pressure-sensitive adhesive). Consequently, the hydroxy-compound-containing pressure-sensitive adhesive layer may be one which has already been regulated so as to have an adhesive strength (in application to silicon mirror wafer; peel angle, 15°; pulling rate, 150 mm/sec; 23±3°C) of 2.3 (N/25-mm width) or lower, or may be one whose adhesive strength (in application to silicon mirror wafer; peel angle, 15°; pulling rate, 150 mm/sec; 23±3°C) can be reduced to 2.3 (N/25-mm width) or lower. A pressure-sensitive adhesive for forming such a hydroxy-compound-containing pressure-sensitive adhesive layer can be suitably selected from conventional pressure-sensitive adhesives.

In the hydroxy-compound-containing pressure-sensitive adhesive layer, the peel adhesive strength (peel angle, 15°; pulling rate, 150 mm/sec; temperature, 23±3°C) in application to a silicon mirror wafer is preferably 1.0 (N/25-mm width) or higher, more preferably 1.1 (N/25-mm width) or higher, especially preferably 1.2 (N/25-mm width) or higher. In the case where the peel adhesive strength (peel angle, 15°; pulling rate, 150 mm/sec; temperature, 23±3°C) of the hydroxy-compound-containing pressure-sensitive adhesive layer in application to a silicon mirror wafer is lower than 1.0 (N/25-mm width), there are cases where cut pieces scatter in dicing a work.

Consequently, in the case where the hydroxy-compound-containing pressure-sensitive adhesive layer in the invention is one which has already been regulated so as to have an adhesive strength (in application to silicon mirror wafer; peel angle, 15°; pulling rate, 150 mm/sec; 23±3°C) of 2.3 (N/25-mm width) or lower [i.e., in the case where the pressure-sensitive adhesive layer is one whose adhesive strength (in application to silicon mirror wafer; peel angle, 15°; pulling rate, 150 mm/sec; 23±3°C) at the time of dicing is 2.3 (N/25-mm width) or lower], the adhesive strength (in application to silicon mirror wafer; peel angle, 15°; pulling rate, 150 mm/sec; 23±3°C) of this hydroxy-compound-containing pressure-sensitive adhesive layer is preferably 1.0 to 2.3 (N/25-mm width), more preferably 1.1 to 2.2 (N/25-mm width), especially preferably 1.2 to 2.1 (N/25-mm width).

In the invention, the hydroxy-compound-containing pressure-sensitive adhesive layer preferably is a hydroxy-compound-containing pressure-sensitive adhesive layer whose adhesive strength (in application to silicon mirror wafer; peel angle, 15°; pulling rate, 150 mm/sec; 23±3°C) at the time of dicing is 1.0 to 2.3 (N/25-mm width). Especially preferred is a hydroxy-compound-containing pressure-sensitive adhesive layer which at the time of dicing has an adhesive strength (in application to silicon mirror wafer; peel angle, 15°; pulling rate, 150 mm/sec; 23±3°C) of 1.0 to 2.3 (N/25-mm width) and which can be further reduced in adhesive strength in preparation for pickup. When such a hydroxy-compound-containing pressure-sensitive adhesive layer is employed, dicing can be conducted while inhibiting or preventing the scattering (shedding) of the resultant cut pieces and the cut pieces can be easily separated from the pressure-sensitive adhesive tape or sheet and picked up while inhibiting or preventing a pressure-sensitive adhesive ingredient from remaining on the cut pieces (i.e., adhesive transfer).

The adhesive strength of the hydroxy-compound-containing pressure-sensitive adhesive layer is determined in the following manner as shown in Fig. 2. The pressure-sensitive adhesive tape or sheet is applied to a silicon mirror wafer. Thereafter, in an environment having a temperature of 23±3°C, the pressure-sensitive adhesive tape or sheet is peeled off by pulling it in the pulling direction "a" at a pulling rate of 150 mm/min while keeping the angle between the surface of the hydroxy-compound-containing pressure-sensitive adhesive layer and the surface of the silicon mirror wafer at 15°. The stress required for this peeling is measured. The maximum value of the stress (maximum of the stress values excluding that corresponding to the peak top in an initial stage of the measurement) is read. This maximum stress value is defined as the adhesive strength (N/25-mm width) of the pressure-sensitive adhesive layer. The reasons why the adhesive strength of the hydroxy-compound-containing pressure-sensitive adhesive layer is specified with the use of a silicon mirror wafer are that silicon mirror wafers have a certain degree of surface smoothness and that the material of silicon mirror wafers is the same as that of the semiconductor wafer or the like for use as the work to be diced and picked up. The reason why the adhesive strength is one determined at a measuring temperature of 23±3°C is that pickup is usually conducted in an environment at room temperature (23°C).

Fig. 2 is a diagrammatic sectional view illustrating a method of measuring the adhesive strength of the pressure-sensitive adhesive tape or sheet. In Fig. 2, numeral 5 denotes a silicon mirror wafer and θ indicates the angle between the surface of the hydroxy-compound-containing pressure-sensitive adhesive layer 3 and the surface of the silicon mirror wafer 5 (peel angle). Symbol a indicates the direction in which the pressure-sensitive adhesive tape or sheet 1 is pulled for peeling (pulling direction). Numerals 1 to 3 denote the pressure-sensitive adhesive tape or sheet, substrate, and hydroxy-compound-containing pressure-sensitive adhesive layer, respectively, as in the embodiment described above. In the method shown in Fig. 2, the pressure-sensitive adhesive tape or sheet 1 which has been applied to one side of the silicon mirror wafer 5 is peeled off by pulling it at a rate of 150 mm/min in the pulling direction "a" at a peel angle θ kept constant at 15°. This measurement of adhesive strength is made in an atmosphere at 23°C. As the silicon mirror wafer is used the wafer available under the trade name of "CZN<100>2.5-3.5 (4 inches)" (manufactured by Shin-Etsu Semiconductor Co., Ltd.; silicon mirror wafer which has been mirror-polished at 23°C).

From the standpoints of preventing chips (cut pieces) from shedding (scattering) during dicing and of improving strippability from chips during pickup, the hydroxy-compound-containing pressure-sensitive adhesive layer in the invention especially preferably is one which can prevent chip shedding when adherent to a semiconductor part (e.g., a semiconductor wafer) as an adherend and which, in preparation for pickup, can be made to have a lower adhesive strength than in application to adherend, i.e., which can be reduced in adhesive strength (in application to silicon mirror wafer; peel angle, 15°; pulling rate, 150 mm/sec; 23±3°C; 65±5% RH) to 2.3 (N/25-mm width) or lower [in this regard, in the case of a hydroxy-compound-containing pressure-sensitive adhesive layer which, at the time of application to an adherend, already has an adhesive strength (in application to silicon mirror wafer; peel angle, 15°; pulling rate, 150 mm/sec; 23±3°C; 65±5% RH) regulated to 2.3 (N/25-mm width) or lower, this pressure-sensitive adhesive layer can be further reduced in adhesive strength]. It is important that the pressure-sensitive adhesive composition to be used for forming such a hydroxy-compound-containing pressure-sensitive adhesive layer should be a pressure-sensitive adhesive composition containing a pressure-sensitive adhesive and 2 to 12% by weight of a hydroxy compound based on all ingredients. Examples of the pressure-sensitive adhesive include an acrylic pressure-sensitive adhesive, rubber-based pressure-sensitive adhesive, silicone pressure-sensitive adhesive, poly(vinyl ether) pressure-sensitive adhesive, urethane pressure-sensitive adhesive, polyester pressure-sensitive adhesive, polyamide pressure-sensitive adhesive, epoxy pressure-sensitive adhesive, and fluororesin pressure-sensitive adhesive. Such pressure-sensitive adhesives may be used alone or in combination of two or more thereof. The pressure-sensitive adhesive to be used for forming the hydroxy-compound-containing pressure-sensitive adhesive layer may be in any form. For example, it may be a pressure-sensitive adhesive in any form such as an emulsion type pressure-sensitive adhesive, solvent-based pressure-sensitive adhesive, heat-melting type pressure-sensitive adhesive (hot-melt pressure-sensitive adhesive), or the like.

An acrylic pressure-sensitive adhesive can be advantageously used as the pressure-sensitive adhesive for forming the hydroxy-compound-containing pressure-sensitive adhesive layer. The acrylic pressure-sensitive adhesive contains an acrylic polymer as the main component or base polymer. The acrylic polymer is a polymer (homopolymer or copolymer) produced from one or more monomers containing a (meth)acrylic ester as the main monomer ingredient. Examples thereof include polymers of (meth)acrylic esters and copolymers obtained by copolymerizing one or more (meth)acrylic esters and one or more monomers (copolymerizable monomers) copolymerizable with the (meth)acrylic esters. By using copolymerizable monomers, the cohesive force, heat resistance, and other properties of the acrylic polymer can be modified.

Examples of the (meth)acrylic esters as the main monomer ingredient for the acrylic polymer include alkyl esters of (meth)acrylic acid, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, and octadecyl (meth)acrylate; cycloalkyl esters of (meth)acrylic acid, such as cyclohexyl (meth)acrylate; and aryl esters of (meth)acrylic acid, such as phenyl (meth)acrylate. Such (meth)acrylic esters can be used alone or in combination of two or more thereof.

From the standpoints of peel adhesive strength, etc., the acrylic polymer preferably has a glass transition temperature (Tg) of -60°C or higher, more preferably has a Tg of -20 to 20°C. From this standpoint, the acrylic polymer preferably contains a (meth)acrylic ester giving a homopolymer having a glass transition temperature of - 60°C or higher as the main monomer ingredient.

In producing the acrylic polymer, copolymerizable monomer may be used as monomer ingredients for the purpose of, for example, modifying properties such as cohesive force and heat resistance according to the necessity as stated above. Copolymerizable monomer may be used alone or in combination of two or more thereof. Examples of the copolymerizable monomers include hydroxyl-containing monomers such as 2-hydroxyethyl (meth)acrylate, 2-hydroxypropyl (meth)acrylate, 4-hydroxybutyl (meth)acrylate, and 6-hydroxyhexyl (meth)acrylate; epoxy-containing monomers such as glycidyl (meth)acrylate; carboxyl-containing monomers such as (meth)acrylic acid (acrylic acid and methacrylic acid), itaconic acid, maleic acid, fumaric acid, crotonic acid, and isocrotonic acid; monomers containing an acid anhydride group, such as maleic anhydride and itaconic anhydride; amide monomers such as (meth)acrylamide, N,N-dimethyl(meth)acrylamide, N-butyl(meth)acrylamide, N-methylol(meth)acrylamide, N-methylolpropane(meth)acrylamide, N-methoxymethyl(meth)acrylamide, and N-butoxymethyl(meth)acrylamide; amino-containing monomers such as aminoethyl (meth)acrylate, N,N-dimethylaminoethyl (meth)acrylate, and t-butylaminoethyl (meth)acrylate; cyano-containing monomers such as (meth)acrylonitrile; olefin monomers such as ethylene, propylene, isoprene, butadiene, and isobutylene; styrene monomers such as styrene, α-methylstyrene, and vinyltoluene; vinyl ester monomers such as vinyl acetate and vinyl propionate; vinyl ether monomers such as methyl vinyl ether and ethyl vinyl ether; monomers containing one or more halogen atoms, such as vinyl chloride and vinylidene chloride; alkoxy-containing monomers such as methoxyethyl (meth)acrylate and ethoxyethyl (meth)acrylate; and monomers having a ring containing one or more nitrogen atoms, such as N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and N-(meth)acryloylmorpholine.

According to the necessity, polyfunctional monomers may be used as copolymerizable monomers for the purpose of crosslinking, etc. Examples of the polyfunctional monomers include 1,6-hexanediol (meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, glycerol di(meth)acrylate, epoxy (meth)acrylates, polyester (meth)acrylates, urethane (meth)acrylates, divinylbenzene, butylene di(meth)acrylate, and hexylene di(meth)acrylate.

Furthermore, an ethylene/vinyl acetate copolymer, a vinyl acetate polymer, or the like can be used as a copolymerizable ingredient according to the necessity.

The acrylic polymer can be prepared by polymerizing a single monomer ingredient or a mixture of two or more monomer ingredients. The polymerization can be conducted by any of the solution polymerization method, emulsion polymerization method, bulk polymerization method, suspension polymerization method, and the like.

From the standpoint of, e.g., preventing the contamination of works such as semiconductor wafers, the acrylic polymer preferably is one in which the content of low-molecular components is low. From this standpoint, the weight-average molecular weight of the acrylic polymer is preferably 300,000 or higher (e.g., 300,000 to 5,000,000), more preferably 300,000 to 3,000,000 (in particular, 500,000 to 3,000,000). When the acrylic polymer has a weight-average molecular weight lower than 300,000, the pressure-sensitive adhesive tape or sheet is reduced in the property of not causing contamination of works such as semiconductor wafers and there are cases where the pressure-sensitive adhesive tape or sheet leaves an adhesive residue upon stripping after application to an active surface.

A crosslinking agent can be suitably used in order to heighten the weight-average molecular weight of the acrylic polymer. The crosslinking agent is not particularly limited, and use may be made of one suitably selected from conventional crosslinking agents (e.g., polyisocyanate crosslinking agents, epoxy crosslinking agents, aziridine compound crosslinking agents, melamine resin crosslinking agents, urea resin crosslinking agents, acid anhydride crosslinking agents, polyamine crosslinking agents, and carboxyl-containing polymeric crosslinking agents). It is important that the amount of the crosslinking agent to be used should be determined so as not to excessively lower the adhesive strength at the time of application. For example, the amount of the crosslinking agent to be used is preferably 0.01 to 5 parts by weight per 100 parts by weight of the polymer to be crosslinked (uncrosslinked acrylic polymer).

In the case where an acrylic polymer is to be crosslinked with a crosslinking agent, it is important that the acrylic polymer should have a functional group (e.g., hydroxyl or carboxyl group) reactive with the crosslinking agent.

The pressure-sensitive adhesive composition for forming the hydroxy-compound-containing pressure-sensitive adhesive layer may contain conventional additives or ingredients such as a tackifier, antiaging agent, filler, colorant, flame retardant, antistatic agent, softener, ultraviolet absorber, antioxidant, plasticizer, and surfactant according to the necessity.

In the invention, the hydroxy-compound-containing pressure-sensitive adhesive layer may be a radiation-curable pressure-sensitive adhesive layer which cures upon irradiation with a radiation. In the case where the hydroxy-compound-containing pressure-sensitive adhesive layer is a radiation-curable pressure-sensitive adhesive layer, the following effects are brought out. When the pressure-sensitive adhesive tape or sheet is applied to an adherend such as a semiconductor wafer, this pressure-sensitive adhesive layer shows excellent pressure-sensitive adhesive properties and can effectively prevent chip shedding during dicing. On the other hand, when this pressure-sensitive adhesive layer is cured by irradiation with a radiation, it comes to have a reduced adhesive strength and show excellent strippability, whereby chip pickup can be effectively conducted. In the case where the hydroxy-compound-containing pressure-sensitive adhesive layer is a radiation-curable pressure-sensitive adhesive layer, the radiation-curable pressure-sensitive adhesive layer is irradiated with a radiation (e.g., X-rays, ultraviolet, or electron beams) after the dicing step. It is therefore preferred to employ a substrate having sufficient transparency to the radiation.

It is important that a radiation-curable pressure-sensitive adhesive composition containing a hydroxy compound in an amount of 2 to 12% by weight based on all ingredients and further containing a radiation-curable pressure-sensitive adhesive should be used for forming a radiation-curable pressure-sensitive adhesive layer as the hydroxy-compound-containing pressure-sensitive adhesive layer. Examples of the radiation-curable pressure-sensitive adhesive include ones prepared by incorporating a radiation-curable ingredient into a base polymer such as those described above (e.g., an acrylic polymer) and ones containing a polymer in which a carbon-carbon double bond is introduced into the molecule (e.g., in the side chain or main chain or at the end of the main chain) of the base polymer containing an acrylic polymer such as those described above as a basic framework (this polymer is often referred to as "double-bond-containing acrylic polymer"). In the case where the base polymer in the radiation-curable pressure-sensitive adhesive is a double-bond-containing acrylic polymer, the following advantage is brought about. When the pressure-sensitive adhesive tape or sheet is applied to an active surface and the adhesion to the active surface is to be reduced thereafter by irradiation with a radiation, then the adhesion to the active surface can be reduced to an even lower level without the need of adding a radiation-curable ingredient (e.g., a low-molecular ingredient such as a monomer or oligomer).

The radiation-curable ingredient is not particularly limited so long as it is a compound having a functional group having radiation polymerizability (property of polymerizing upon irradiation with a radiation), such as a group containing a carbon-carbon double bond (often referred to as "carbon-carbon double-bond-containing group"). It may be either a monomer ingredient or an oligomer ingredient. Examples of the radiation-curable ingredient include esters of (meth)acrylic acid with a polyhydric alcohol, such as trimethylolpropane tri(meth)acrylate, pentaerythritol tri(meth)acrylate, tetraethylene glycol di(meth)acrylate, 1,6-hexanediol di(meth)acrylate, neopentyl glycol di(meth)acrylate, dipentaerythritol hexa(meth)acrylate, and glycerol di(meth)acrylate; ester acrylate oligomers; cyanurate compounds having one or more carbon-carbon double-bond-containing groups, such as 2-propenyl di-3-butenyl cyanurate; and isocyanurate compounds having one or more carbon-carbon double-bond-containing groups, such as tris(2-acryloxyethyl) isocyanurate, tris(2-methacryloxyethyl) isocyanurate, 2-hydroxyethyl bis(2-acryloxyethyl) isocyanurate, bis(2-acryloxyethyl) 2-[(5-acryloxyhexyl)oxy]ethyl isocyanurate, tris(1,3-diacryloxy-2-propyloxycarbonylamino-n-hexyl) isocyanurate, tris(1-acryloxyethyl-3-methacryloxy-2-propyloxycarbonylamino-n-hexyl) isocyanurate, and tris(4-acryloxy-n-butyl) isocyanurate. It is preferred to use a radiation-curable ingredient which contains 6 or more carbon-carbon double-bond-containing groups on the average in the molecule.

The viscosity of the radiation-curable ingredient is not particularly limited. Radiation-curable ingredients may be used alone or in combination of two or more thereof.

The amount of the radiation-curable ingredient to be incorporated is not particularly limited. However, from the standpoint of reducing the peel adhesive strength in preparation for pickup, i.e., through irradiation with a radiation, it is desirable to incorporate the ingredient in an amount of 20% by weight or larger (preferably 25 to 60% by weight, more preferably 25 to 55% by weight) based on all ingredients in the radiation-curable pressure-sensitive adhesive composition.

On the other hand, in the radiation-curable pressure-sensitive adhesive composition to be used for forming the radiation-curable pressure-sensitive adhesive layer, the double-bond-containing acrylic polymer preferably is a double-bond-containing acrylic polymer in which at least 1% of the side chains in the molecule each have one carbon-carbon double bond. Such double-bond-containing acrylic polymers need not contain low-molecular ingredients such as an oligomer ingredient or do not contain such ingredients in a large amount. Consequently, the migration of low-molecular ingredients such as an oligomer ingredient in a radiation-curable pressure-sensitive adhesive layer with the lapse of time can be inhibited or prevented and a radiation-curable pressure-sensitive adhesive layer having a stable layer structure can be formed.

Methods for preparing a double-bond-containing acrylic polymer (i.e., methods for introducing carbon-carbon double bonds into an acrylic polymer) are not particularly limited. Examples thereof include a method which includes copolymerizing monomers including a monomer having a functional group as a copolymerizable monomer to prepare an acrylic polymer containing the functional group (often referred to as "functional-group-containing acrylic polymer") and then causing a compound having both a functional group reactive with the functional group contained in the functional-group-containing acrylic polymer and a carbon-carbon double bond to undergo condensation reaction or addition reaction with the functional-group-containing acrylic polymer while maintaining the radiation curability (radiation polymerizability) of the carbon-carbon double bond to thereby prepare a double-bond-containing acrylic polymer.

It is preferred that the radiation-curable pressure-sensitive adhesive layer contain a photopolymerization initiator so as to enable the radiation-curable ingredient or the double-bond-containing acrylic polymer to efficiently polymerize or cure upon irradiation with a radiation. Examples of the photopolymerization initiator include benzoin alkyl ether initiators such as benzoin methyl ether, benzoin ethyl ether, benzoin propyl ether, benzoin isopropyl ether, and benzoin isobutyl ether; benzophenone initiators such as benzophenone, benzoylbenzoic acid, 3,3'-dimethyl-4-methoxybenzophenone, and polyvinylbenzophenone; aromatic ketone initiators such as α-hydroxycyclohexyl phenyl ketone, 4-(2-hydroxyethoxy)phenyl 2-hydroxy-2-propyl ketone, α-hydroxy-α,α'-dimethylacetophenone, methoxyacetophenone, 2,2-dimethoxy-2-phenylacetophenone, 2,2-diethoxyacetophenone, and 2-methyl-1-[4-(methylthio)phenyl]-2-morpholinopropane-1; aromatic ketal initiators such as benzyl dimethyl ketal; thioxanthone initiators such as thioxanthone, 2-chlorothioxanthone, 2-methylthioxanthone, 2-ethylthioxanthone, 2-isopropylthioxanthone, 2-dodecylthioxanthone, 2,4-dichlorothioxanthone, 2,4-dimethylthioxanthone, 2,4-diethylthioxanthone, and 2,4-diisopropylthioxanthone; benzil initiators such as benzil; and benzoin initiators such as benzoin. Examples thereof further include α-ketol compounds (such as 2-methyl-2-hydroxypropiophenone), aromatic sulfonyl chloride compounds (such as 2-naphthalenesulfonyl chloride), optically active oxime compounds (such as 1-phenyl-1,1-propanedione-2-(o-ethoxycarbonyl) oxime), camphorquinone, halogenated ketones, acylphosphinoxides, and acylphosphonates. Such photopolymerization initiators can be used alone or in combination of two or more thereof.

The amount of the photopolymerization initiator to be incorporated can be suitably selected in the range of 0.5 to 30 parts by weight (preferably 1 to 20 parts by weight) per 100 parts by weight of the radiation-curable ingredient or the double-bond-containing acrylic polymer.

The hydroxy-compound-containing pressure-sensitive adhesive layer in the invention may be a heat-peelable pressure-sensitive adhesive layer constituted of a heat-peelable pressure-sensitive adhesive composition. Even when the pressure-sensitive adhesive layer is a heat-peelable pressure-sensitive adhesive layer, this pressure-sensitive adhesive tape or sheet enables the work to be easily separated therefrom and can have satisfactory suitability for pickup. Examples of the heat-peelable pressure-sensitive adhesive composition for forming the heat-peelable pressure-sensitive adhesive layer include a heat-peelable pressure-sensitive adhesive composition containing a base polymer such as those described above (e.g., an acrylic polymer) and a blowing agent incorporated therein, such as heat-expandable fine particles. After accomplishment of the purpose of bonding a work, the heat-peelable pressure-sensitive adhesive layer is heated to thereby blow or expand the heat-peelable pressure-sensitive adhesive layer and make the surface of the heat-peelable pressure-sensitive adhesive layer have irregularities. As a result, the area of adhering to the work decreases and the adhesive strength decreases accordingly. Thus, the work can be easily separated from the pressure-sensitive adhesive layer.

The heat-expandable fine particle are not particularly limited, and can be suitably selected, for example, from conventional inorganic or organic heat-expandable microspheres. Heat-expandable fine particles obtained by microencapsulating a heat-expandable substance are also usable.

The hydroxy-compound-containing pressure-sensitive adhesive layer can be formed from a pressure-sensitive adhesive composition (preferably, a radiation-curable pressure-sensitive adhesive composition) containing a hydroxy compound in an amount of 2 to 12% by weight based on all ingredients, by a conventional method of forming a pressure-sensitive adhesive layer. For example, for forming the hydroxy-compound-containing pressure-sensitive adhesive layer on a substrate, use may be made of: a method in which a pressure-sensitive adhesive composition containing a hydroxy compound in an amount of 2 to 12% by weight based on all ingredients is applied to a given side of a substrate to form the target pressure-sensitive adhesive layer; or a method in which a pressure-sensitive adhesive composition containing a hydroxy compound in an amount of 2 to 12% by weight based on all ingredients is applied to a separator (e.g., a plastic film or sheet coated with a release agent) to form a hydroxy-compound-containing pressure-sensitive adhesive layer and this hydroxy-compound-containing pressure-sensitive adhesive layer is transferred to a given side of a substrate.

The hydroxy-compound-containing pressure-sensitive adhesive layer may be composed of a single layer or superposed layers.

Pressure-Sensitive Adhesive Tape or Sheet for Application to Active Surface in Dicing

As shown in Fig. 1, the pressure-sensitive adhesive tape or sheet for application to an active surface in dicing of the invention has a substrate and a hydroxy-compound-containing pressure-sensitive adhesive layer which is formed on at least one side (on one side or both sides) of the substrate and contains a hydroxy compound in an amount of 2 to 12% by weight based on all ingredients. In the invention, the pressure-sensitive adhesive tape or sheet preferably has a constitution (embodiment) in which the hydroxy-compound-containing pressure-sensitive adhesive layer is formed on one side of the substrate. According to the necessity, however, the pressure-sensitive adhesive tape or sheet may have a constitution in which hydroxy-compound-containing pressure-sensitive adhesive layers are formed on both sides of the substrate. Furthermore, it may have a constitution in which a hydroxy-compound-containing pressure-sensitive adhesive layer is formed on one side of the substrate and a pressure-sensitive adhesive layer other than the hydroxy-compound-containing pressure-sensitive adhesive layer is formed on the other side of the substrate.

The pressure-sensitive adhesive tape or sheet of the invention may optionally have a separator as shown in Fig. 1 for the purpose of, e.g., protecting the hydroxy-compound-containing pressure-sensitive adhesive layer or another pressure-sensitive adhesive layer. The separator is not particularly limited, and one suitably selected from conventional separators can be used. Examples of the constituent material of the separator (material of the base) include papers; and synthetic resin films made of synthetic resins such as polyethylene, polypropylene, and poly(ethylene terephthalate). A surface of the separator may have undergone a releasant treatment (releasability-imparting treatment) such as a silicone treatment, treatment with a long-chain alkyl type releasant, or fluorochemical treatment so as to have enhanced releasability from the hydroxy-compound-containing pressure-sensitive adhesive layer according to the necessity. Furthermore, the separator may have undergone an ultraviolet-shielding treatment according to the necessity so as to prevent the hydroxy-compound-containing pressure-sensitive adhesive layer from reacting by the action of environmental ultraviolet. The thickness of the separator is not particularly limited. However, it is generally 10 to 200 µm (preferably 25 to 100 µm).

When the pressure-sensitive adhesive tape or sheet of the invention has a constitution in which a hydroxy-compound-containing pressure-sensitive adhesive layer is formed on one side of the substrate, this pressure-sensitive adhesive tape or sheet may have, formed on the other side of the substrate, a pressure-sensitive adhesive layer of another kind (pressure-sensitive adhesive layer containing no hydroxy compound), a releasing layer formed by a releasability-imparting treatment, etc. For forming the pressure-sensitive adhesive layer of another kind, use may be made of, for example, a pressure-sensitive adhesive composition containing at least one pressure-sensitive adhesive selected from conventional pressure-sensitive adhesives (acrylic pressure-sensitive adhesives, rubber-based pressure-sensitive adhesives, urethane pressure-sensitive adhesives, silicone pressure-sensitive adhesives, polyester pressure-sensitive adhesives, polyamide pressure-sensitive adhesives, epoxy pressure-sensitive adhesives, vinyl alkyl ether pressure-sensitive adhesives, fluororesin pressure-sensitive adhesives, etc.) and optional various additives, a radiation-curable ingredient, a blowing agent, etc. Furthermore, the release agent (releasant) to be used for forming a releasing layer on the other side of the substrate is not particularly limited, and use may be made of one suitably selected from conventional release agents (silicone release agents, long-chain alkyl type release agents, fluorochemical release agents, etc.).

The pressure-sensitive adhesive tape or sheet of the invention may be in a roll form or in the form of a stack of sheets. When the pressure-sensitive adhesive tape or sheet of the invention is to be used for the dicing of a semiconductor wafer, it is generally cut into a given shape before use.

It is important that the pressure-sensitive adhesive tape or sheet of the invention should be applied to a surface (active surface) in the state of being not wholly covered with a native oxide film. On the active surface, active atoms in an unoxidized state (often referred to as "active atoms") are present. These active atoms have the property of being capable of forming a chemical bond with a component of the pressure-sensitive adhesive layer. Namely, an active surface is a surface in which unoxidized-state atoms having reactivity with a component of the pressure-sensitive adhesive layer are present. In the invention, the pressure-sensitive adhesive tape or sheet, even after having been kept adherent to such an active surface for a prolonged period of time, can be made easily strippable from the active surface by, e.g., irradiation with a radiation. The component of the pressure-sensitive adhesive layer with which active atoms can form a chemical bond may be a compound having a functional group reactive with the active atoms. Examples thereof include base polymers, tackifier resins, and radiation-curable ingredients.

Examples of the work having an active surface include semiconductor wafers, semiconductor packages, glasses, and ceramics. Such works are made of a material including a compound such as a silicon compound, germanium compound, or gallium-arsenic compound. After such a work is subjected to back grinding or the like to expose a new surface (fresh surface), active atoms in an unoxidized state, such as active silicon atoms (Si) in an unoxidized state, active germanium atoms (Ge) in an unoxidized state, or active gallium atoms (Ga) in an unoxidized state, are present on the newly exposed surface. Incidentally, these active atoms can be deactivated through oxidation with the lapse of time (oxidation by natural exposure) or by forced oxidation, etc. to thereby become inactive.

Even after the pressure-sensitive adhesive tape or sheet of the invention has been kept adherent to that active surface of a work which was exposed by grinding or the like for thickness reduction and has active atoms which have not been deactivated, i.e., in an active state, for the purpose of improving tact time, protecting the work having a reduced thickness, etc., it can be made easily strippable by effectively reducing the adhesion to the active surface of the work by, e.g., irradiation with a radiation, regardless of the period of adhesion. Consequently, even when the pressure-sensitive adhesive tape or sheet of the invention is applied, subsequently to or shortly after a wafer back grinding step or a grinding dust layer removal step (step of mechanical grinding dust layer removal, chemical grinding dust layer removal, or grinding dust layer removal by both) conducted after the wafer back grinding step, to an active surface newly exposed by the grinding (i.e., even when the pressure-sensitive adhesive tape or sheet is thus applied in a mounting step), this pressure-sensitive adhesive tape or sheet can be effectively utilized in subsequent steps such as a dicing step and a pickup step. Specifically, before the dicing step, the pressure-sensitive adhesive tape or sheet has the function of effectively protecting the brittle work having a reduced thickness (e.g., semiconductor wafer). In the dicing step, the pressure-sensitive adhesive tape or sheet has the function of highly tenaciously fixing the work and enabling it to be efficiently diced. Furthermore, in the pickup step, the pressure-sensitive adhesive tape or sheet can be effectively reduced in the adhesion to the work by, e.g., irradiation with a radiation and thereby functions to enable cut pieces of the work (e.g., semiconductor elements) to be easily picked up.

Consequently, the pressure-sensitive adhesive tape or sheet of the invention can be advantageously used as a pressure-sensitive adhesive tape or sheet for dicing which is to be applied to an active surface in the state of being not wholly covered with a native oxide film.

### Method of Picking up Cut Pieces of Work

In the method of picking up cut pieces of a work according to the invention, the pressure-sensitive adhesive tape or sheet is applied to an active surface of a work and then this work is diced. Thereafter, the resultant cut pieces are picked up. It is important that the pressure-sensitive adhesive tape or sheet be applied to a work so that the surface of the hydroxy-compound-containing pressure-sensitive adhesive layer comes into contact with the active surface of the work. Since the pressure-sensitive adhesive tape or sheet as described above is used for the dicing of a work and the pickup of cut pieces, the pickup of cut pieces of the work can be made easy by, e.g., irradiation with a radiation even after the pressure-sensitive adhesive tape or sheet for dicing has been kept adherent to the active surface of the work for a prolonged time period. An improved yield can hence be attained. Furthermore, in the pickup method, even when a brittle semiconductor wafer (semiconductor device) having a thickness as small as below 100 µm is used as a work, semiconductor chips obtained by dicing the semiconductor wafer into a given size can be easily picked up and the yield can be effectively improved.

As described above, the method of picking up cut pieces of a work according to the invention at least includes: a mounting step in which the pressure-sensitive adhesive tape or sheet is applied to an active surface of a work; a dicing step for dicing the work (cutting the work into pieces) after the mounting step; and a pickup step for picking up the resultant cut pieces of the work after the dicing step.

The mounting step is conducted in order that the pressure-sensitive adhesive tape or sheet is applied to an active surface of a work. A general procedure in the mounting step includes superposing a work such as a semiconductor wafer, on the pressure-sensitive adhesive tape or sheet so that the active surface of the work comes into contact with the pressure-sensitive adhesive surface on the hydroxy-compound-containing pressure-sensitive adhesive layer side and then bonding the work to the pressure-sensitive adhesive tape or sheet while pressing them with a known pressing device such as a pressing device having a pressure roll. Alternatively, use may be made of a method in which a work is superposed on the pressure-sensitive adhesive tape or sheet in the same manner as in the method described above in a vessel capable of pressurizing (e.g., an autoclave) and the inside of the vessel is pressurized to thereby bond the work to the pressure-sensitive adhesive tape or sheet. In this bonding with pressurizing, the work may be bonded to the pressure-sensitive adhesive tape or sheet for application to an active surface in dicing while further pressing them with a pressing device. It is also possible to bond the work to the pressure-sensitive adhesive tape or sheet in a reduced-pressure chamber (vacuum chamber) in the same manner as described above. Although the temperature at which the pressure-sensitive adhesive tape or sheet is applied is not particularly limited, it is preferably 20 to 80°C.

The dicing step is conducted in order to produce cut pieces (e.g.; semiconductor chips) of the work (e.g., semiconductor wafer) adhered to the pressure-sensitive adhesive tape or sheet, by dicing the work into separate pieces. In the dicing step, the dicing of the work adhered to the pressure-sensitive adhesive tape or sheet is conducted in an ordinary way. In the case where the work is a semiconductor wafer, dicing is conducted usually from the circuit side of the semiconductor wafer. In this dicing step, a blade is generally rotated at a high speed to cut the work such as a semiconductor wafer, into a given size. For this dicing step, use may be made of, e.g., the cutting technique called full cutting, in which the work is cut up to a depth reaching the pressure-sensitive adhesive tape or sheet. Dicing apparatus are not particularly limited, and one suitably selected from known dicing apparatus can be used. In the dicing step, since the work such as a semiconductor wafer is finely adhered and fixed to the pressure-sensitive adhesive tape or sheet, the chips are inhibited or prevented from chipping or shedding. In addition, the work itself, such as semiconductor wafer, is inhibited or prevented from breaking.

The pickup step is conducted in order that the cut pieces of the work which are adhered to the pressure-sensitive adhesive tape or sheet are separated and picked up from the pressure-sensitive adhesive tape or sheet. In the pickup step, the cut pieces (e.g., semiconductor chips) of the work which are in the state of being adhered to the pressure-sensitive adhesive tape or sheet are picked up. Methods for this pickup are not particularly limited, and any of various known pickup methods can be employed. Examples thereof include a method in which individual cut pieces are pushed up with needles from the pressure-sensitive adhesive tape or sheet side and the cut pieces thus pushed up are picked up with a pickup apparatus. It is important that when the hydroxy-compound-containing pressure-sensitive adhesive layer is a radiation-curable pressure-sensitive adhesive layer or heat-peelable pressure-sensitive adhesive layer, the pickup should be conducted after irradiation with a radiation or after a heat treatment. Irradiation with a radiation or a heat treatment may be conducted before pickup in the pickup step or may be conducted prior to the pickup step. Examples of the radiation with which the pressure-sensitive adhesive tape or sheet is irradiated include α-rays, β -rays, γ-rays, neutron beams, electron beams, and ultraviolet. Ultraviolet is especially preferred. Various conditions for the irradiation with a radiation, such as irradiation intensity and irradiation period, are not particularly limited, and can be suitably set according to the necessity. On the other hand, when a heat treatment is conducted, various heating conditions including heating temperature and heating period are not particularly limited and can be suitably set according to the necessity.

It is important that the mounting step be conducted after the wafer back grinding step and when the surface newly exposed is an active surface. Namely, it is generally important that the mounting step be conducted successively to the wafer back grinding step or to the wafer back grinding step and the subsequent step of grinding dust layer removal, etc. (i.e., immediately after the wafer back grinding step or the step of grinding dust layer removal) or shortly after the step (i.e., within several hours after completion of the wafer back grinding step or the step of grinding dust layer removal) at the time when the active surface newly exposed has not been deactivated and retains an active state. It is also important that the dicing step be conducted after the mounting step. For example, the dicing step may be conducted successively to or shortly after the mounting step, or may be conducted after the lapse of a long time from the mounting step. Furthermore, it is important that the pickup step be conducted after the dicing step. For example, the pickup step may be conducted successively to or shortly after the dicing step, or may be conducted after the lapse of a long time from the dicing step. It is a matter of course that other steps (e.g., a cleaning step and an expanding step) may be conducted between the mounting step and dicing step or between the dicing step and pickup step.

### Semiconductor Device

The semiconductor device of the invention is produced by dicing a semiconductor wafer and picking up a resultant cut piece, which is obtainable by using the method of picking up cut pieces of a work described above. Consequently, the semiconductor device can be obtained while attaining excellent suitability for pickup regardless of adhesion period even when the pressure-sensitive adhesive tape or sheet for application to an active surface in dicing has been applied to an active surface and pickup is conducted thereafter.

### EXAMPLES

The invention will be explained below in more detail by reference to Examples, but the invention should not be construed as being limited by the following Examples.

### EXAMPLE 1

Seventy-five parts by weight of methyl acrylate, 10 parts by weight of methoxyethyl acrylate, 5 parts by weight ofN-vinylpyrrolidone, and 10 parts by weight of 2-hydroxyethyl acrylate were copolymerized in ethyl acetate by an ordinary method to obtain a solution containing an acrylic copolymer (acrylic copolymer solution A).

To the acrylic copolymer solution A were added 12 parts by weight of 2-methacryloyloxyethyl isocyanate and 0.1 part by weight of dibutyltin dilaurate as a catalyst. The resultant mixture was reacted at 50°C for 24 hours to obtain a solution containing a double-bond-containing acrylic polymer having carbon-carbon double bonds at side-chain ends (weight-average molecular weight, 600,000) (the solution is referred to as double-bond-containing acrylic polymer solution A). This double-bond-containing acrylic polymer has a structure in which 90% by mole of the side-chain terminal hydroxyl groups (hydroxyl groups derived from the 2-hydroxyethyl acrylate) of the acrylic copolymer have undergone an addition reaction with the isocyanate group of the 2-methacryloyloxyethyl isocyanate.

Subsequently, 70 parts by weight of an ultraviolet-curable oligomer (viscosity at 25°C, 10 Pa·sec) obtained by reacting pentaerythritol triacrylate with a diisocyanate, 3 parts by weight of "Irgacure 651" (trade name; manufactured by Ciba Specialty Chemicals Co.) as a photopolymerization initiator, 2 parts by weight of a polyisocyanate compound (trade name "Coronate L", manufactured by Nippon Polyurethane Co., Ltd.), and 10 parts by weight of polypropylene glycol having a number-average molecular weight of 2,000 were added to the double-bond-containing acrylic polymer solution A. Thus, an ultraviolet-curable acrylic pressure-sensitive adhesive solution (ultraviolet-curable acrylic pressure-sensitive adhesive solution A) was obtained.

As a substrate was used a film made of linear low-density polyethylene (thickness, 70 µm) one side of which had undergone a corona discharge treatment.

The ultraviolet-curable acrylic pressure-sensitive adhesive solution A was applied to the corona discharge-treated side of the substrate. The coating was heated at 80°C for 10 minutes to thermally crosslink the acrylic polymer. Thus, an ultraviolet-curable pressure-sensitive adhesive layer (thickness, 5 µm) was formed as a radiation-curable pressure-sensitive adhesive layer on the substrate. Subsequently, a separator was adhered to the surface of the ultraviolet-curable pressure-sensitive adhesive layer to produce an ultraviolet-curable pressure-sensitive adhesive sheet for dicing. The ultraviolet-curable pressure-sensitive adhesive layer contains the polypropylene glycol as a hydroxy-containing compound or derivative thereof in an amount of 5.4% by weight based on all ingredients.

### EXAMPLE 2

A double-bond-containing acrylic polymer solution A was obtained in the same manner as in Example 1. To this double-bond-containing acrylic polymer solution A were added 50 parts by weight of an ultraviolet-curable oligomer (viscosity at 25°C, 10 Pa·sec) obtained by reacting pentaerythritol triacrylate with a diisocyanate, 3 parts by weight of "Irgacure 651" (trade name; manufactured by Ciba Specialty Chemicals Co.) as a photopolymerization initiator, 2 parts by weight of a polyisocyanate compound (trade name "Coronate L", manufactured by Nippon Polyurethane Co., Ltd.), and 20 parts by weight of polypropylene glycol having a number-average molecular weight of 1,000. Thus, an ultraviolet-curable acrylic pressure-sensitive adhesive solution (ultraviolet-curable acrylic pressure-sensitive adhesive solution B) was obtained.

As a substrate was used the same film as in Example 1, i.e., a film made of linear low-density polyethylene (thickness, 70 µm) one side of which had undergone a corona discharge treatment.

An ultraviolet-curable pressure-sensitive adhesive sheet for dicing was produced in the same manner as in Example 1, except that the ultraviolet-curable acrylic pressure-sensitive adhesive solution B was used. The ultraviolet-curable pressure-sensitive adhesive layer contains the polypropylene glycol as a hydroxy-containing compound or derivative thereof in an amount of 11.4% by weight based on all ingredients.

### EXAMPLE 3

A double-bond-containing acrylic polymer solution A was obtained in the same manner as in Example 1. To this double-bond-containing acrylic polymer solution A were added 120 parts by weight of an ultraviolet-curable oligomer (viscosity at 25°C, 10 Pa·sec) obtained by reacting pentaerythritol triacrylate with a diisocyanate, 3 parts by weight of "Irgacure 651" (trade name; manufactured by Ciba Specialty Chemicals Co.) as a photopolymerization initiator, 2 parts by weight of a polyisocyanate compound (trade name "Coronate L", manufactured by Nippon Polyurethane Co., Ltd.), and 5 parts by weight of polypropylene glycol having a number-average molecular weight of 1,000. Thus, an ultraviolet-curable acrylic pressure-sensitive adhesive solution (ultraviolet-curable acrylic pressure-sensitive adhesive solution C) was obtained.

As a substrate was used the same film as in Example 1, i.e., a film made of linear low-density polyethylene (thickness, 70 µm) one side of which had undergone a corona discharge treatment.

An ultraviolet-curable pressure-sensitive adhesive sheet for dicing was produced in the same manner as in Example 1, except that the ultraviolet-curable acrylic pressure-sensitive adhesive solution C was used. The ultraviolet-curable pressure-sensitive adhesive layer contains the polypropylene glycol as a hydroxy-containing compound or derivative thereof in an amount of 2.1 % by weight based on all ingredients.

### COMPARATIVE EXAMPLE 1

A double-bond-containing acrylic polymer solution A was obtained in the same manner as in Example 1. To this double-bond-containing acrylic polymer solution A were added 70 parts by weight of an ultraviolet-curable oligomer (viscosity at 25°C, 10 Pa·sec) obtained by reacting pentaerythritol triacrylate with a diisocyanate, 3 parts by weight of "Irgacure 651" (trade name; manufactured by Ciba Specialty Chemicals Co.) as a photopolymerization initiator, and 2 parts by weight of a polyisocyanate compound (trade name "Coronate L", manufactured by Nippon Polyurethane Co., Ltd.). Thus, an ultraviolet-curable acrylic pressure-sensitive adhesive solution (ultraviolet-curable acrylic pressure-sensitive adhesive solution D) was obtained.

As a substrate was used the same film as in Example 1, i.e., a film made of linear low-density polyethylene (thickness, 70 µm) one side of which had undergone a corona discharge treatment.

An ultraviolet-curable pressure-sensitive adhesive sheet for dicing was produced in the same manner as in Example 1, except that the ultraviolet-curable acrylic pressure-sensitive adhesive solution D was used. The ultraviolet-curable pressure-sensitive adhesive layer contains no hydroxy-containing compound or derivative thereof.

### COMPARATIVE EXAMPLE 2

A double-bond-containing acrylic polymer solution A was obtained in the same manner as in Example 1. To this double-bond-containing acrylic polymer solution A were added 70 parts by weight of an ultraviolet-curable oligomer (viscosity at 25°C, 10 Pa·sec) obtained by reacting pentaerythritol triacrylate with a diisocyanate, 3 parts by weight of "Irgacure 651" (trade name; manufactured by Ciba Specialty Chemicals Co.) as a photopolymerization initiator, 2 parts by weight of a polyisocyanate compound (trade name "Coronate L", manufactured by Nippon Polyurethane Co., Ltd.), and 2 parts by weight of polypropylene glycol having a number-average molecular weight of 1,000. Thus, an ultraviolet-curable acrylic pressure-sensitive adhesive solution (ultraviolet-curable acrylic pressure-sensitive adhesive solution E) was obtained.

As a substrate was used the same film as in Example 1, i.e., a film made of linear low-density polyethylene (thickness, 70 µm) one side of which had undergone a corona discharge treatment.

An ultraviolet-curable pressure-sensitive adhesive sheet for dicing was produced in the same manner as in Example 1, except that the ultraviolet-curable acrylic pressure-sensitive adhesive solution E was used. The ultraviolet-curable pressure-sensitive adhesive layer contains the polypropylene glycol as a hydroxy-containing compound or derivative thereof in an amount of 0.009% by weight based on all ingredients.

### COMPARATIVE EXAMPLE 3

A double-bond-containing acrylic polymer solution A was obtained in the same manner as in Example 1. To this double-bond-containing acrylic polymer solution A were added 50 parts by weight of an ultraviolet-curable oligomer (viscosity at 25°C, 10 Pa·sec) obtained by reacting pentaerythritol triacrylate with a diisocyanate, 5 parts by weight of "Irgacure 651" (trade name; manufactured by Ciba Specialty Chemicals Co.) as a photopolymerization initiator, 5 parts by weight of a polyisocyanate compound (trade name "Coronate L", manufactured by Nippon Polyurethane Co., Ltd.), and 35 parts by weight of polypropylene glycol having a number-average molecular weight of 1,000. Thus, an ultraviolet-curable acrylic pressure-sensitive adhesive solution (ultraviolet-curable acrylic pressure-sensitive adhesive solution F) was obtained.

As a substrate was used the same film as in Example 1, i.e., a film made of linear low-density polyethylene (thickness, 70 µm) one side of which had undergone a corona discharge treatment.

An ultraviolet-curable pressure-sensitive adhesive sheet for dicing was produced in the same manner as in Example 1, except that the ultraviolet-curable acrylic pressure-sensitive adhesive solution F was used. The ultraviolet-curable pressure-sensitive adhesive layer contains the polypropylene glycol as a hydroxy-containing compound or derivative thereof in an amount of 18% by weight based on all ingredients.

### EVALUATION

The pressure-sensitive adhesive sheets for dicing obtained in Examples 1 to 3 and Comparative Examples 1 to 3 were evaluated or examined for suitability for pickup, adhesive strength, and suitability for dicing by the method of evaluating suitability for pickup, method of measuring adhesive strength, and method of evaluating suitability for dicing shown below. Comprehensive evaluation was further conducted based on the results of that evaluation or measurement. The evaluation results obtained are shown in Table 1.

### Method of Evaluating Suitability for Pickup

Each of the pressure-sensitive adhesive sheets for dicing obtained in the Examples and Comparative Examples was mounted on the ground side of a 6-inch silicon wafer (thickness, 100 µm) which had undergone back grinding under the following back grinding conditions. This mounting was conducted in an environment of 23°C immediately after the grinding (within 5 minutes after completion of the grinding). Subsequently, the silicon wafer was diced under the following dicing conditions to form semiconductor chips.

After the lapse of a given time period (6 hours or 7 days) from the mounting, the pressure-sensitive adhesive sheet for dicing was irradiation with ultraviolet from the back side thereof (irradiation period, 20 seconds; irradiation intensity, 500 mJ/cm²). Thereafter, 50 arbitrary semiconductor chips were picked up (separated from the sheet) under the following pickup conditions, and the number of semiconductor chips which could be successfully picked up (number of pickup successes) was counted. The case where all semiconductor chips were successfully picked up was judged "good" and the other cases were judged "poor". Suitability for pickup was thus evaluated.

### (Back Grinding Conditions)

Grinder: "DFG-840" manufactured by DISCO Corp.

First spindle: #600 grinding wheel (rotation speed, 4,800 rpm; down speed: P1, 3.0 µm/sec; P2, 2.0 µm/sec)

Second spindle: #2000 grinding wheel (rotation speed, 5,500 rpm; down speed: P1, 0.8 µm/sec; P2, 0.6 µm/sec)

The back side of a silicon wafer was ground by 30 µm with the second spindle and then ground to a final silicon wafer thickness of 100 µm.

### (Dicing Conditions)

Dicer: "DFD-651" manufactured by DISCO Corp.
Blade: "27HECC" manufactured by DISCO Corp.
Blade rotation speed: 40,000 rpm
Dicing speed: 120 mm/sec
Dicing depth: 25 µm
Cutting mode: down cutting
Dicing size: 5.0 mm × 5.0 mm

### (Pickup Conditions)

Die bonder: "Machinery CPS-100" manufactured by NEC Corp.
Number of pins: 4
Distance between pins: 3.5 mm × 3.5 mm
Curvature of pin tip: 0.250 mm
Pin pushing-up amount: 0.50 mm
Suction holding time: 0.2 sec
Expanding amount: 3 mm

### Method of Measuring Adhesive strength

Each of the pressure-sensitive adhesive sheets for dicing obtained in the Examples and Comparative Examples was cut into a strip having a width of 25 mm. This strip was applied in an atmosphere of 23°C (room temperature) to a mirror silicon wafer (silicon mirror wafer) which had been mirror-polished (trade name "CZN <100> 2.5-3.5 (4 inches)" manufactured by Shin-Etsu Semiconductor Co., Ltd.). Thereafter, the resultant test piece was allowed to stand for 30 minutes in the room-temperature atmosphere and then irradiated with ultraviolet from the back side of the pressure-sensitive adhesive sheet for dicing (irradiation period, 20 seconds; irradiation intensity, 500 mJ/cm²).

After the ultraviolet irradiation, the pressure-sensitive adhesive sheet for dicing was stripped off by pulling it at a pulling rate of 150 mm/min in the pulling direction "a" so that the angle between the surface of the pressure-sensitive adhesive layer and the surface of the mirror silicon wafer (peel angle) θ was 15°, as shown in Fig. 2, to measure the adhesive strength. The pressure-sensitive adhesive sheets which gave a found value of adhesive strength of 2.3 N/25-mm width or lower were judged "good", while those which gave a found value of adhesive strength higher than 2.3 N/25-mm width were judged "poor". Thus, the pressure-sensitive adhesive sheets were evaluated for adhesive strength.

### Method of Evaluating Suitability for Dicing

Each of the pressure-sensitive adhesive sheets for dicing obtained in the Examples and Comparative Examples was mounted on the ground side of a 6-inch silicon wafer (thickness, 100 µm) which had undergone back grinding under the same back grinding conditions as in the method of evaluating suitability for pickup. This mounting was conducted in an environment of 23°C immediately after the grinding (within 5 minutes after completion of the grinding). Subsequently, the silicon wafer was diced into a size of 3 mm x 3 mm with dicer "DFD651", manufactured by DISCO Corp. After the dicing, the number of chips having a size of 3 mm x 3 mm which had scattered was counted. The case where none of the chips had scattered was judged "good" and the other cases were judged "poor". Suitability for dicing was thus evaluated.

Incidentally, the blade used for the dicing was "27HECC", manufactured by DISCO Corp., and the dicing speed was 80 mm/s. The depth of cutting into the pressure-sensitive adhesive sheet for dicing was regulated to 25 µm.

### COMPREHENSIVE EVALUATION

The cases where all of the evaluation items concerning suitability for pickup, adhesive strength, and suitability for dicing were "good" were judged "good". On the other hand, the cases where at least one of the evaluation items was "poor" were judged "poor". Comprehensive evaluation was thus conducted.

**Table 1**

| | | | Example | | | Comparative Example | | |
|---|---|---|---|---|---|---|---|---|
| | | | 1 | 2 | 3 | 1 | 2 | 3 |
| Pickup | After 6 hours | Number of pickup successes | 50 | 50 | 50 | 28 | 45 | 50 |
| | | Evaluation of suitability for pickup | good | good | good | poor | poor | good |
| | After 7 days | Number of pickup successes | 50 | 50 | 50 | 0 | 15 | 50 |
| | | Evaluation of suitability for pickup | good | good | good | poor | poor | good |
| Adhesive strength (15°, 150 mm/min, 23°C) | Found value (N/25 mm) | | 1.9 | 1.3 | 2.0 | 3.1 | 2.6 | 0.9 |
| | Evaluation of adhesive strength | | good | good | good | good | poor | good |
| Suitability for dicing | Number of scattered chips | | 0 | 0 | 0 | 0 | 0 | 15 |
| | Evaluation of suitability for dicing | | good | good | good | good | good | poor |
| Comprehensive evaluation | | | good | good | good | poor | poor | poor |

As apparent from Table 1, the pressure-sensitive adhesive sheets for dicing according to Examples 1 to 3 were judged good in the comprehensive evaluation. Specifically, dicing could be conducted without causing chip scattering. These pressure-sensitive adhesive sheets were ascertained to have excellent suitability for dicing. Furthermore, all the semiconductor chips could be satisfactorily picked up after the lapse of 6 hours from mounting or even after the lapse of 7 days from mounting. These pressure-sensitive adhesive sheets were ascertained to have excellent suitability for pickup.

This application is based on Japanese patent application No. 2006-237149 filed September 1, 2006.

## Claims

1. A pressure-sensitive adhesive tape or sheet for dicing, which comprises a substrate and a pressure-sensitive adhesive layer disposed on at least one side of the substrate,
wherein said pressure-sensitive adhesive layer disposed on at least one side of the substrate contains a polyalkylene glycol in an amount of 2 to 12% by weight based on all ingredients, and
wherein the pressure-sensitive adhesive tape or sheet is to be applied to an active surface in the state of being not wholly covered with a native oxide film.

2. The pressure-sensitive adhesive tape or sheet according to claim 1, wherein the polyalkylene glycol is polyethylene glycol or polypropylene glycol.

3. The pressure-sensitive adhesive tape or sheet according to claim 1, wherein the polyalkylene glycol is polypropylene glycol.

4. The pressure-sensitive adhesive tape or sheet according to claim 1, wherein the pressure-sensitive adhesive layer is a radiation-curable pressure-sensitive adhesive layer.

5. A method of picking up a cut piece of a work, comprising:
applying the pressure-sensitive adhesive tape or sheet according to claim 1 to an active surface of a work, followed by dicing the work; and then
picking up a resultant cut piece of the work.

6. The method according to claim 5, wherein the work is a semiconductor wafer having a thickness of smaller than 100 µm.

7. A semiconductor device produced by dicing a semiconductor wafer and picking up a resultant cut piece, the semiconductor device being obtainable by the method according to claim 5.

## Patentansprüche

1. Haftklebeband oder -folie zum Trennen (dicing), welche(s) ein Substrat und eine auf wenigstens einer Seite des Substrats angeordnete Haftklebeschicht umfasst,
wobei die auf wenigstens einer Seite des Substrats angeordnete Haftklebeschicht ein Polyalkylenglycol in einer Menge von 2 bis 12 Gew.-%, bezogen auf alle Inhaltsstoffe, enthält, und
wobei das Haftklebeband oder die Haftklebefolie auf eine aktive Oberfläche in dem Zustand einer nicht vollständigen Bedeckung mit einem nativen Oxidfilm aufgebracht werden soll.

2. Haftklebeband oder -folie nach Anspruch 1, wobei das Polyalkylenglycol Polyethylenglycol oder Polypropylenglycol ist.

3. Haftklebeband oder -folie nach Anspruch 1, wobei das Polyalkylenglycol Polypropylenglycol ist.

4. Haftklebeband oder -folie nach Anspruch 1, wobei die Haftklebeschicht eine strahlungshärtbare Haftklebeschicht ist.

5. Verfahren zum Aufnehmen eines geschnittenen Teils eines Erzeugnisses, umfassend:
Aufbringen des Haftklebebands oder der Haftklebefolie nach Anspruch 1 auf eine aktive Oberfläche eines Erzeugnisses, gefolgt vom Trennen des Erzeugnisses; und anschließend Aufnehmen eines resultierenden geschnittenen Teils des Erzeugnisses.

6. Verfahren nach Anspruch 5, wobei das Erzeugnis ein Halbleiterwafer mit einer Dicke von weniger als 100 µm ist.

7. Halbleitervorrichtung hergestellt durch Trennen eines Halbleiterwafers und Aufnehmen eines resultierenden geschnittenen Teils, wobei die Halbleitervorrichtung durch das Verfahren nach Anspruch 5 erhältlich ist.

## Revendications

1. Ruban adhésif sensible à la pression ou feuille adhésive sensible à la pression pour débitage, qui comprend un substrat et une couche adhésive sensible à la pression disposée sur au moins un côté du substrat,
où ladite couche adhésive sensible à la pression disposée sur au moins un côté du substrat contient un polyalkylèneglycol en une quantité de 2 à 12 % en poids sur la base de tous les ingrédients, et
où le ruban adhésif sensible à la pression ou la feuille adhésive sensible à la pression est destiné à être appliqué à une surface active dans l'état n'étant pas complètement recouverte d'un film d'oxyde natif.

2. Ruban adhésif sensible à la pression ou feuille adhésive sensible à la pression selon la revendication 1, où le polyalkylèneglycol est le polyéthylèneglycol ou le polypropylèneglycol.

3. Ruban adhésif sensible à la pression ou feuille adhésive sensible à la pression selon la revendication 1, où le polyalkylèneglycol est le polypropylèneglycol.

4. Ruban adhésif sensible à la pression ou feuille adhésive sensible à la pression selon la revendication 1, où la couche adhésive sensible à la pression est une couche adhésive sensible à la pression durcissable par rayonnement.

5. Procédé de prélèvement d'un fragment coupé d'une pièce d'oeuvre, comprenant :
l'application du ruban adhésif sensible à la pression ou de la feuille adhésive sensible à la pression selon la revendication 1 à une surface active d'une pièce d'oeuvre, suivie par le débitage de la pièce d'oeuvre ; puis
le prélèvement d'un fragment coupé résultant de la pièce d'oeuvre.

6. Procédé selon la revendication 5, où la pièce d'oeuvre est une plaquette semi-conductrice ayant une épaisseur inférieure à 100 µm.

7. Dispositif semi-conducteur produit par débitage d'une plaquette semi-conductrice et prélèvement d'un fragment coupé résultant, le dispositif semi-conducteur pouvant être obtenu par le procédé selon la revendication 5.
